# EUROPEAN PATENT SPECIFICATION

(11) **EP 1 289 319 B1**
(45) Date of publication and mention of the grant of the patent: **17.02.2010**
(21) Application number: 01309116.0
(22) Date of filing: 26.10.2001
(51) Int. Cl.: H04Q 1/10, H05K 7/14

(54) **Accommodation apparatus for communication devices**
Aufnahmegerät für Kommunikationseinrichtungen
Logement pour dispositifs de communications

(30) Priority: 04.09.2001 JP 2001266927
(43) Date of publication of application: 05.03.2003
(73) Proprietor: Allied Telesis Holdings K.K., Shinagawa-ku, Tokyo (JP)
(72) Inventor: Tomino, Hiroyuki, c/o Allied Telesis Kabushiki K., Shinagawa-ku, Tokyo 141-8635 (JP)
(74) Representative: Faulkner, Thomas John

(56) References cited:
- DE-A1- 4 230 418
- DE-B- 1 236 611
- US-A- 5 761 030
- US-B1- 6 181 549
- US-B1- 6 249 441

## Description

The present invention relates generally to accommodation apparatuses for accommodating a communication device. The present invention is suitable, for example, for an accommodation apparatus for accommodating a communication device such as a media converter. The media converter, as used herein, is a device that converts a signal propagating through one transmission medium to a signal for a different transmission medium. These different transmission media include, for instance, an optical fiber cable and an Unshielded Twisted Pair ("UTP") cable, and an optical fiber cable (of a single mode) and an optical fiber cable (of a multimode).

According to the CSMA/CD (Carrier Sense Multiple Access with Collision Detection) as the MAC (Media Access Control) technology used typically for a LAN (Local Area Network), a station attempting to transmit data confirms a presence of another transmission and starts data transmission when confirming that there is no transmission. A high-speed LAN that achieves a base band transmission of signals at a transmission speed of 100Mbps is called the 100BASE standard, which includes the 100BASE-TX and 100BASE-FX. The 100BASE-TX uses a UTP cable as a transmission medium, while 100BASE-FX uses an optical fiber cable as a transmission medium.

Media converters that convert a signal for one transmission medium to a signal for another transmission medium have recently been demanded increasingly, because they may provide not only a LAN Ethernet with signal transmissions using an optical fiber cable of several kilometers but also FTTH (Fiber To The Home) inexpensively. The rapid developments of the optical fiber cables and LANs/WANs (Wide Area Networks) have demanded use of scores of media converters.

There are racks that often load and house a plurality of media converters, each of which has, for example, 100BASE-TX and 100BASE-FX ports. Such racks realize, while standardized, for example, by the JIS (Japanese Industrial Standards) and the EIA (Electronic Industries Alliance), a centralized management of media converters.

It is often preferred to use a plurality of media converters having a few ports to use one media converter having many ports for exchange, operation, and wire configuration purposes. For instance, when each media converter is assigned to a different area, an area affected by an exchange of one faulty media converter can be limited to that the area assigned to the broken media converter.

Nevertheless, the conventional rack does not have such a structure that it may facilitate attachments, exchanges, operations, and wire configurations of the media converters:

First, conventional racks use a tray, fixed onto a frame, to house several media converters in a row, and come to demand multistage, stacked trays so as to use a multiplicity of media converters. Therefore, in attaching a media converter to one tray or in exchanging a media converter from one tray, an upper tray just above the one tray should be arduously removed from the frame. The same problem occurs when a power unit is mounted onto one tray.

In addition, a certain type of small media converter has, for example, a 100BASE-TX port at its front surface, a 100BASE-FX at its back surface, and various operational switches at its top surface. Therefore, in order to manipulate various switches at the top surface of the media converter on the tray, it is necessary to arduously remove the upper tray just above it or inconveniently insert a finger between the top surface of the media converter and the upper tray.

Moreover, where the media converter is mounted on the tray such that the front surface of the media converter faces the tray's front surface, the 100BASE-FX port faces tray's rear surface. Then, it is difficult to pull out an optical fiber cable connected to the 100BASE-FX port from the tray's front surface, reducing the network wire configuration flexibility.

DE 1236611B discloses a mounting receptacle for electrical devices. The receptacle comprises a number of drawer-like modules which can slide in and out of the receptacle on rails.

DE 4230418A1 discloses an allocation module comprising a pivotally mounted chassis. The chassis comprises a horizontal base plate and a vertical front plate and has amounting devices for splice and/or coupling elements.

Therefore, it is an exemplified object of the present invention to provide an accommodation apparatus that facilitates attachments, exchanges, operations, and wire configurations of a communication device, such as a media converter, a power unit, and the like.

According to the present invention there is provided an accommodation apparatus according to claim 1. According to this accommodation apparatus, the movement of the loading part relative to the support part facilitates an exchange and operation of the communication device. In addition, the multistage, stacked support parts may reduce an accommodation space for the communication devices, and the above feature facilitates its exchange, operation, and wiring construction. This structure also maintains a wider space for the transmission medium, than the conventional structure in which the power unit is level with the communication device, preventing the transmission medium from getting damaged due to bending. In particular, this feature is desired when the transmission medium is a vulnerable optical fiber.

It is preferable that the support part has one or more slits for guiding out a power cable that connects the power unit to an external power supply, the slit extending in a moving direction of the first loading member. Such a slit is used in cooperation with a tie to fix the power cable, and extends in the moving direction, moving and power cable as the first loading member moves and preventing the power cable from getting damaged. By providing plural slits for one power cable, the power cable may be flexibly pulled out in a direction that does not apply the force to the power cable.

Preferably, the second loading member includes a radiation hole to protect the power unit and/or the communication device from thermal damages. The first loading member may further load the communication device, and include an opening for enabling the transmission medium to be accommodated in the second loading member, and wherein the radiation hole is connected to the opening. This structure enables the opening to serve as a heat radiation function and a path for the transmission medium.

The second loading member may include different first and second surfaces, and the transmission medium is connectible to the communication device through the first and second surfaces of the second loading member. The network wire configuration becomes flexible since the transmission medium is connectible to the communication device through two surfaces, such as the first and second surfaces. The second loading member may include a front plate part with an opening through which the transmission medium is connected to the communication device through the first surface. This structure may pull out the transmission medium from the first surface.

The first loading member may include a bridge part that holds the communication device by a mechanical engagement. The mechanical engagement between the bridge part and the communication device saves trouble of screwing the communication device.

The accommodation apparatus may comprise a restraint part that restricts a moving distance of the loading part relative to the support part, preventing the transmission medium from getting damaged since the loading part does not separate far from the support part. This feature is particularly desired when the transmission medium is a vulnerable optical fiber. The loading part preferably has a radiation hole for radiating heat from the communication devices to protect them from thermal damages.

Preferably, the transmission medium includes first and second transmission media, and the communication device is a media converter which converts a signal for a first transmission medium to a signal for a second transmission medium, and wherein the first transmission medium is connected to the media converter through the first surface of the loading part, and the second transmission medium is connected to the media converter through the first and second surfaces of the loading part. For example, the first transmission medium is a UTP cable, while the second transmission medium is an optical fiber cable.

The communication device may include an operational switch that exposes from the support part as the loading part moves. The exposure from the support part as the loading part moves facilitates operations of the switch.

The loading part may have a grip to move the loading part relative to the support part. This grip facilitates a movement of the loading part.

The communication device may have a housing, and the loading part includes an engagement part that is to be engaged with the housing of the communication device to accommodate the communication device detachably in the loading part. This facilitates an attachment and detachment of the communication device without a tool, such as a screwdriver.

Other objects and further features of the present invention will become readily apparent from the following description of preferred embodiments with reference to accompanying drawings.
FIG. 1 is a schematic perspective view of an accommodation apparatus according to one embodiment of the present invention.
FIG. 2 is a perspective view of a sub-rack for use with the accommodation apparatus shown in FIG. 1.
FIG. 3A is an exploded perspective view of a tray part of a sub-rack shown in FIG. 2, and FIG. 3B is a perspective view after the tray is assembled.
FIGs. 4A and 4B are sectional views showing two modifications of a bridge part for use with the sub-rack shown in FIG. 2.
FIGs. 5A and 5B, respectively, are bottom and rear views of the sub-rack shown in FIG. 2.
FIG. 6 is a left side view of the sub-rack shown in FIG. 2 and its enlarged view for explaining a stopper mechanism.
FIGs. 7A and 7B, respectively, are top and front views of the sub-rack shown in FIG. 2.
FIGs. 8A and 8B, respectively, are perspective and front views of a media converter to be accommodated in the accommodation apparatus shown in FIG. 1.

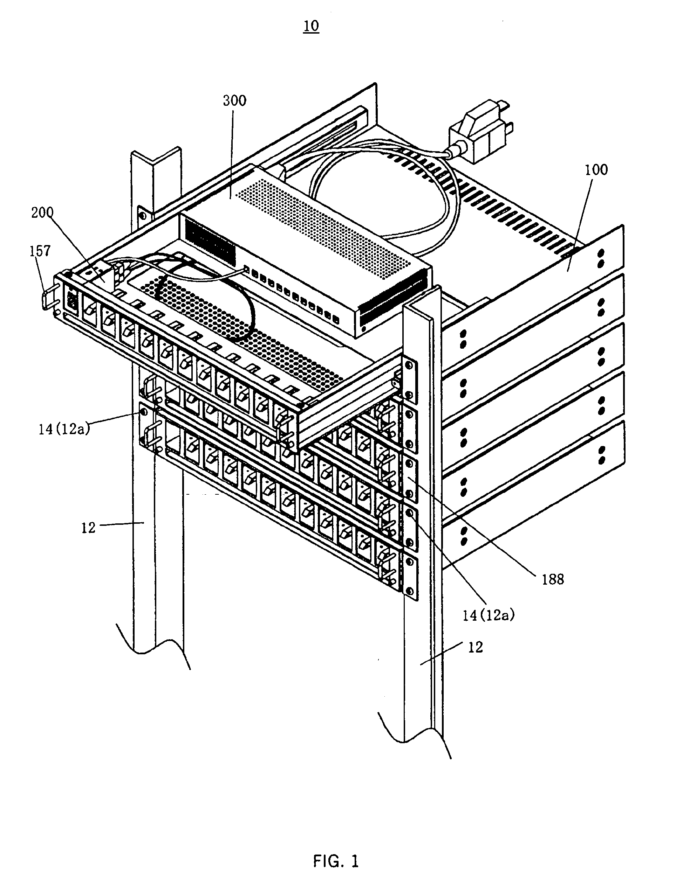

A description will now be given of an accommodation apparatus 10 according to one embodiment of the present invention with reference to the accompanied drawings. Here, FIG. 1 is a schematic perspective view of the accommodation apparatus 10. The accommodation apparatus (or rack) 10 includes stacked, multistage sub-racks 100 for accommodating a plurality of media converters 200 and one power unit 300, which is fixed onto a pair of frames 12 through a pair of fixing parts 188 and screws 14. Thus, the accommodation apparatus 10 may house many media converters 200 in a small space.

The frame 12 has an L-shape as an example in this embodiment, and a plurality of screw holes 12a for fixing the sub-rack 100. The frame 12 is made of metal in this embodiment, but may be made of plastic, wood and other materials as long as it supports the sub-rack 100.

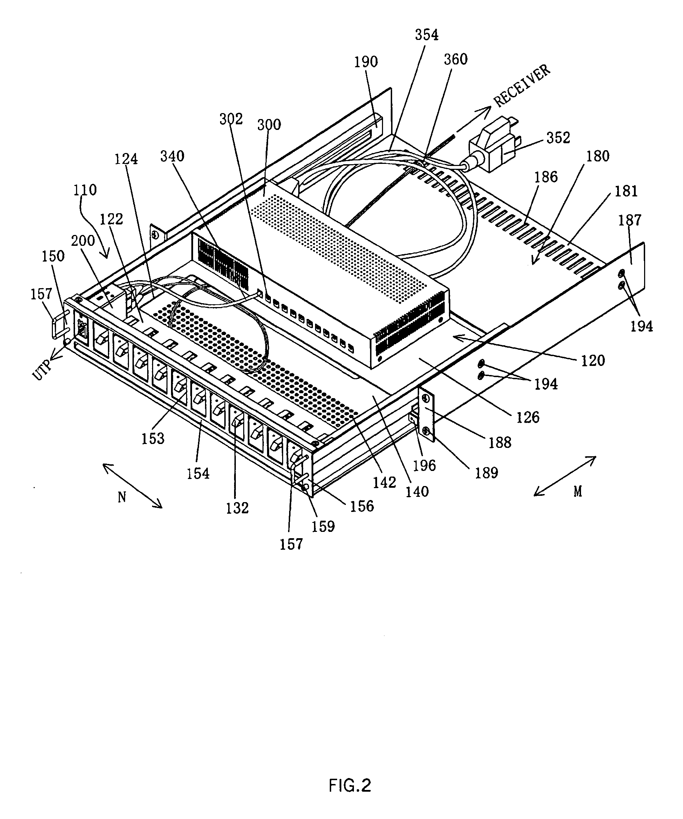

A description will now be given of a structure of the sub-rack 100 with reference to FIGs. 2-5. Here, FIG. 2 is a perspective view of the sub-rack 100. The sub-rack 100 is, for example, one incorporated into EIA300D defined 19" rack. The sub-rack 100 detachably accommodates the media converter 200, and facilitates the exchange, operation, and wire arrangement of the media converter 200. The sub-rack 100 includes a tray part 110 and bracket part 180.

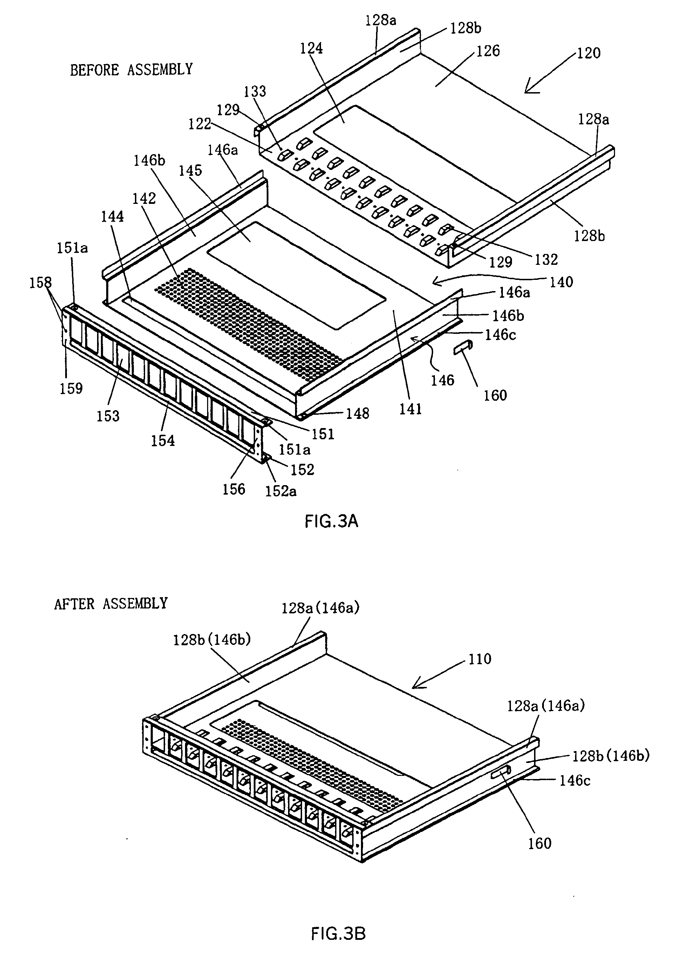

The tray part 110 is connected to the bracket part 180 while movable in a direction M relative to the bracket part 180. The tray part 110 includes upper, lower and front plate parts 120, 140, 150. A description will be given of the tray part 110 with reference to FIGs. 3A and 3B. Here, FIG. 3A is an exploded perspective view of the tray part 110, and FIG. 3B is a perspective view of the assembled tray part 110.

The upper plate part 120, overlaid on the lower plate part 140, holds the media converters 200 and power unit 300, by engaging its side part 128's top part 128a with side part 146's top part 146a of the lower plate part 140, and screwing screw holes 129 and front plate part 150's screw holes 151a. The upper plate part 120 includes a front part 122, a middle hole 124, a rear part 126, and a pair of side parts 128. The upper plate part 120 is formed, for example, by bending one metal plate member in an approximately U shape.

The front part 122 has bridge parts 132 and screw holes 133, to hold and fix the media converters 200.

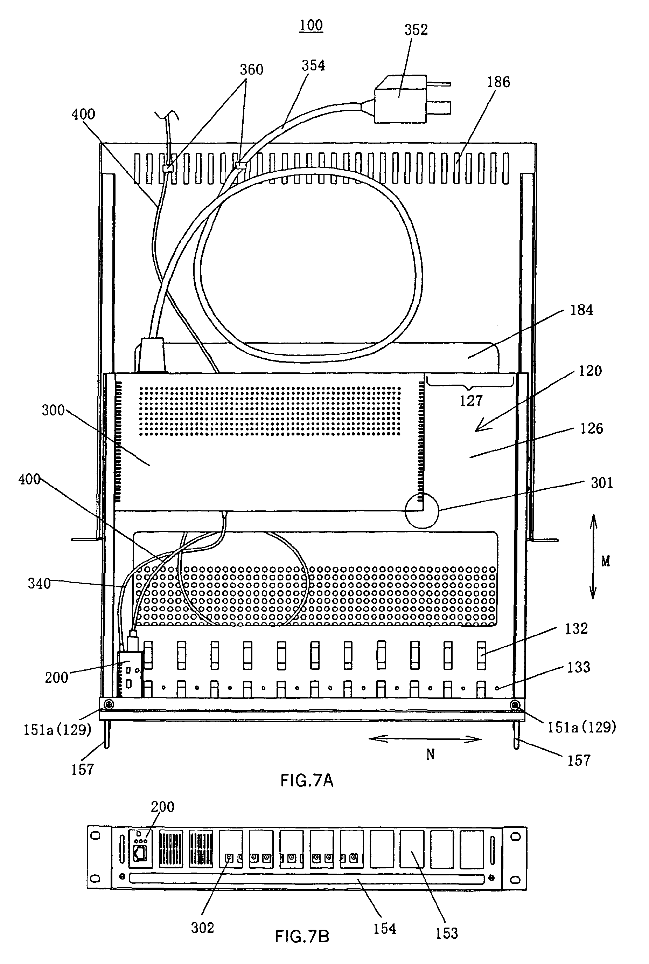

The bridge part 132 has an approximately rectangular parallelepiped shape having a predetermined height, and positions each media converter 200, preventing its rotation during its use. As best shown in FIG. 7A, there are formed two bridge parts 132 in the direction M and eleven bridge parts 132 in a direction N orthogonal to the direction M. A media converter 200 may be inserted between two adjacent bridge parts 132, and between the bridge part 132 and the side part 128. Here, FIGs. 7A and 7B, respectively, are top and front views of the sub-rack 100.

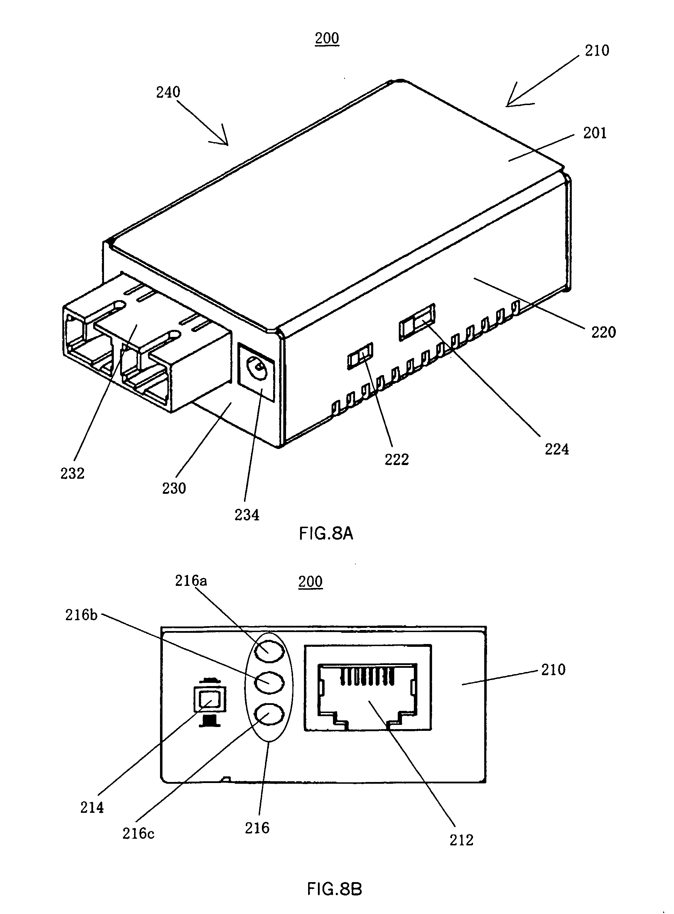

As shown in FIGs. 3A and 7A, twelve screw holes 133 are aligned with the direction N between two bridge parts 132 aligned in the direction M, and each is connected to a screw hole (not shown) in a bottom surface 240 of the media converter 200 shown in FIG. 8A. Each media converter 200 is fixed at the bridge part(s) 132 by screwing the screw hole of the media converter 200 and the screw hole 133 from the backside of the front part 122. Here, FIGs. 8A and 8B, respectively, are perspective and front views of the media converter 200.

The screw hole 133 strongly secures the media converter 200, but arduously requires a tool, such as a screwdriver, for its attachment. Accordingly, in an alternative embodiment, a mechanical engagement between the bridge part 132 and the media converter 200 fixes the media converter 200 at the bridge part(s) 132. Such a mechanical engagement may use any method known in the art.

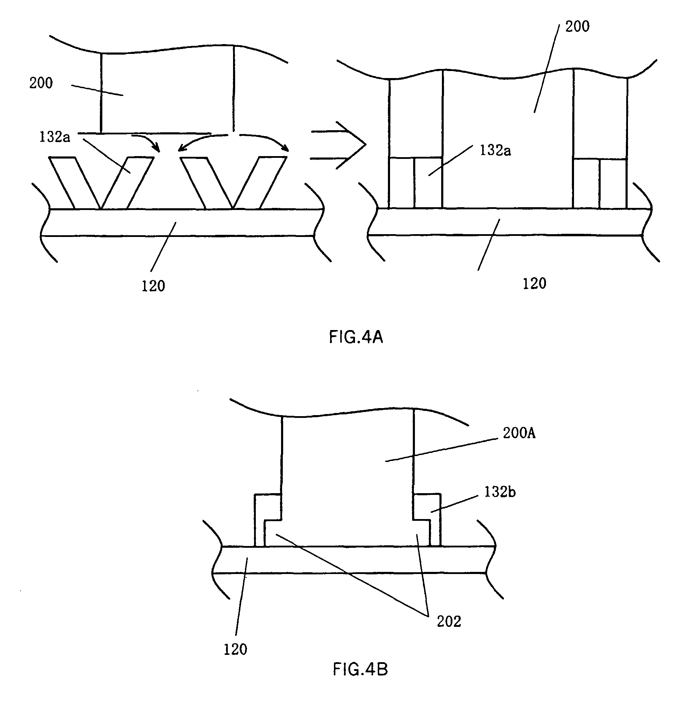

For example, as shown in FIG. 4A, the bridge parts 132 may be replaced with bridge parts 132a made, for example, of an elastic leaf spring, etc. Here, FIG. 4A is a schematic sectional view of a modification of the bridge part 132. The elastic force applies to the bridge parts 132a in an arrow direction, and fix the media converter 200 by opening the bridge parts 132 using a certain means in a reverse direction and inserting the media converter 200 between two adjacent bridge part 132.

Alternatively, the bridge parts 132 may be replaced with L-shaped bridge parts 132b shown in FIG. 4B, and the media converter 200 may be replaced with a media converter 200A. Here, FIG. 4B is schematic sectional views of another modification of the bridge part 132. The bridge part 132b has a wider bottom width, close to the upper plate part 120, than its top width. In addition, the media converter 200A is different from the media converter 200 in that its housing has a wider width, close to the bottom 240 shown in FIG. 8A. The media converter 200A may be fixed at the bridge parts 132b by inserting the wider bottom of the media converter 200A into the wider bottom of the bridge part 132b from front to back or from back to front.

Turning back to FIG. 3A, an optical fiber cable 400 connected to the media converter 200 perforates through the middle hole 124 in the upper plate part 120. As discussed later, the optical fiber cable 400 is vulnerable and thus must maintain a predetermined radius of curvature. In addition, depending upon the network wire configuration, there is a need to pull out the optical fiber cable 400 from the front or rear surface of the accommodation apparatus 10. The middle hole 124 together with the lower plate part 140 accommodates the optical fiber cable 400 at an elevation different from that for the media converters 200 and power unit 300.

Thereby, in pulling out the optical fiber cable 400 from either the front or back of the accommodation apparatus 10, the media converter 200 and power unit 300 do not stand in its way. If the optical fiber cable 400 and the power unit 300 are located on the same plane, the optical fiber 400 would be pulled out from the back surface through the area 127 shown in FIG. 7A next to the power unit 300 on the rear part 126. Then, the optical fiber 400 connected to the leftmost media converter 200 in FIG. 7A would possibly bend at a corner 301 of the power unit 300 and be broken. Thus, the middle hole 124 secures that the optical fiber 400 is pulled out safely. The middle hole 124 may be made of plural (for example, twelve) holes to correspond to the number of media converters 200, but the wider the better as in this embodiment so as to introduce the optical fiber cable 400 into the bottom plate part 140 as well as to keep the predetermined radius of curvature.

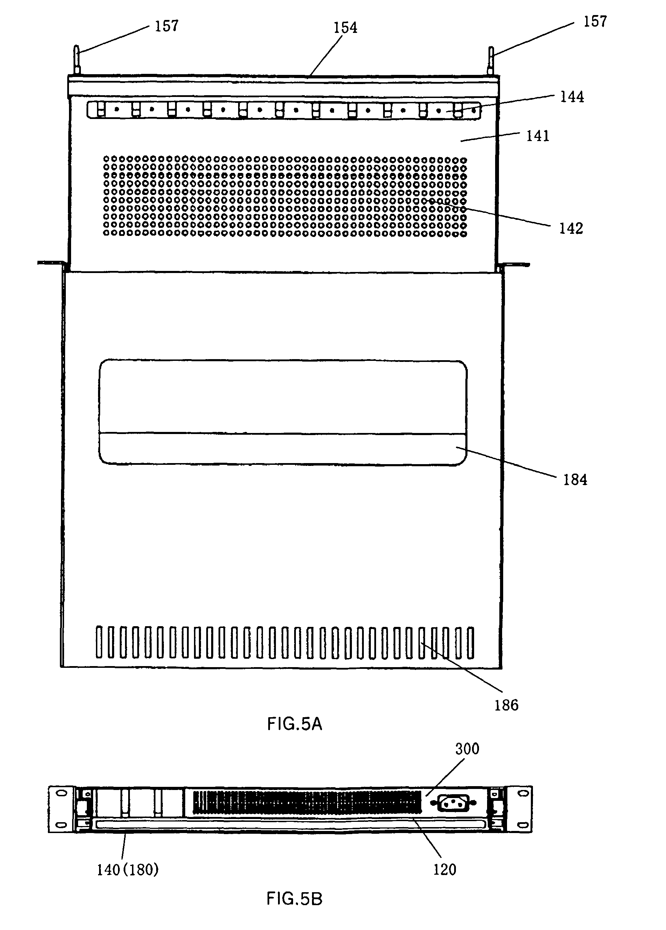

The middle hole 124 is connected to a radiation hole 142 and an opening 184 shown in FIG. 5A, which will be described later, serving as a radiation hole. Here, FIGs. 5A and 5B, respectively, are bottom and rear views of the sub-rack 100.

In a modification to the instant embodiment, the media converter 200 is located on the top or lower plate part 120, 140, the power unit 300 is located on the lower plate part 140, and the optical fiber cable 400 is pulled out from the rear surface of the accommodation apparatus 10 through the rear part 126 of the upper plate part 120.

Turning back to FIG. 3A, the rear part 126 of the upper plate part 120 loads the power unit 300. The rear part 126 is slightly longer than the power unit 300 in the direction M and narrower than the power unit 300 in the direction N. The rear part 126 forms the area 127 as shown in FIG. 7A. If necessary, one or more radiation holes may be formed in the rear part 126.

The upper plate part 120 includes a pair of side parts 128, each of which includes the top part 128a, and a middle part 128b.

The top part 128a of the side part 128 is bent outwardly like a U shape, engaged with the side plate part 146 of the lower plate part 140, which will be described later, and fixed onto the front plate part 150 through the screw holes 129 connected to the screw holes 151 a in the front plate part 150.

The middle part 128b of the side part 128 stands perpendicular from the upper plate part 120, and is higher than at least the media converter 200 and the power unit 300.

Turning back to FIG. 3A, the lower plate part 140 accommodates the optical fiber cable 400 connected to the media converter 200, and enables the optical fiber cable 400 to be pulled out from both the front and back surfaces. The lower plate part 140 includes, as shown in FIG. 3A, a bottom plate 141 and a pair of side plate parts 146. The lower plate part 140 is formed, for example, by bending one metal plate member, and supports the upper plate part 120 using the side plate parts 146.

Radiation holes 142, an opening 144, and a cutout portion 145 are formed in the bottom plate 141. The bottom plate 141 is wide enough to accommodate a surplus portion of the optical fiber cable 400. Since the standard determines the cable length of the optical fiber cable 400, and a surplus portion is often left. The bottom plate 141 in this embodiment accommodates the surplus portion of the connected optical fiber cable 400, and protects the optical fiber cable 400 from excessive bending and damages. The optical fiber cable 400 accommodated in the bottom plate 141 may be pulled out from the front surface through a notch 154 in the front plate part 150, or from the back surface shown in FIG. 5B.

The radiation holes 142 are a multiplicity of meshed holes connected to the middle hole 124 in the upper plate part 120, so as to radiate the heat from the media converter 200 and the power unit 300.

The opening 144 is formed, as shown in FIGs. 3A and 5A, so that it is connected to the front part 122 of the upper plate part 120. Each media converter 200 is screwed through its screw hole (not shown) in the bottom surface 240, the screw hole 133 and the opening 144.

The cutout portion 145 facilitates a fixation of the power unit 300 using screws from the backside in mounting the power unit 300 onto the upper plate part 120.

The side plate part 146 has an approximately U shape viewed from the front including a pair of top parts 146a, a pair of middle parts 146b, and a pair of bottom part 146c. The top part 146a is equipped with an outwardly bent L shape and engaged with the side part 128 of the upper plate part 120.

The middle part 146b stands perpendicular from the bottom plate 141 and fixes a stopper 160 using a screw hole (not shown) provided at the middle part 146b.

The stopper 160 has an L shape, and prevents not only damages and disconnections of the optical fiber cable 400 and power unit cable 304, but also coming off of the tray 110 from the bracket part 180.

The bottom parts 146c are provided orthogonal to the middle parts 146b, and fixed onto the front plate part 150 through screw holes 148 connected to the screw holes 152a.

The front plate part 150 is located perpendicular to the upper and lower plate parts 120 and 140, and approximately level with the side plates 187 of the bracket part 180, which will be described later. The front plate part 150 has upper and lower parts 151 and 152, windows 153, notch 154, and both edges 156.

The front plate part 150 forms the upper and lower parts 151 and 152 parallel to the upper and lower plate parts 120 and 140, by bending a top and a bottom of one plate into an L shape. The upper part 151 has screw holes 151a to fix the front plate part 150 using screws and screw holes 129 provided in the upper plate part 120, while the lower part 152 has screw holes 152a to fix the front plate part 150 using screws and screw holes 148 provided in the lower plate part 140.

The front plate part 150 has twelve rectangular windows 153 corresponding to the front surfaces 210 of the media converters 200. The UTP cable can be connected to the 100BASE-TX port 212 at the front surface 210 of the media converter 200 through the window 153.

As best shown in FIG. 7A, the notch 154 provided in the front plate part 150 covers a range in which the media converters 200 are mounted. The notch 154 enables the optical fiber cable 400 through the front surface of the sub-rack 100, making flexible the network wire configuration of the sub-rack 100.

Each edge 156 of the front plate part 150 screws a handle 157 through two screw holes 158 and screws 159.

The handle 157 is a metal or plastic, approximately U-shaped grip which a user moves the tray part 110 relative to the bracket part 180. The handle 157 is screwed onto the front plate part 150 through the screw holes 158. The handle 157 easily moves the tray part 110 relative to the bracket part 180 even though multistage sub-racks 100 are stacked as shown in FIG. 1. Drawing of the tray part 110 from the bracket part 180 facilitates the exchange, operation and wire configuration of the media converter 200, as described later.

The screw 159 provided in the front plate part 150 is to fix the tray part 110 onto the bracket part 180 through a projection 196 provided on the bracket part 180, which will be described later, after the tray part 110 is pushed in completely.

The bracket part 180, formed by bending one metal plate member into an approximately U shape, movably supports the tray part 110, and has a bottom plate 181 and a pair of side plates 187.

The bottom plate 181 includes an opening 184 and a plurality of slits 186. The opening 184 radiates, in cooperation with the radiation holes 142 in the lower plate part 140, the heat from the media converter 200 and the power unit 300. Each slit 186 is a groove extending in the direction M to allow the power cable 354 move through it and fix it using a tie 360. Since the slit 186 extends in the direction M, the power cable 304 is prevented from being severed while the tray part 110 moves in the direction M. Although all the slits 186 are rarely used simultaneously, plural pieces enable the power cable 354 to be fixed and pulled out using one that does not apply the force to the power cable 354.

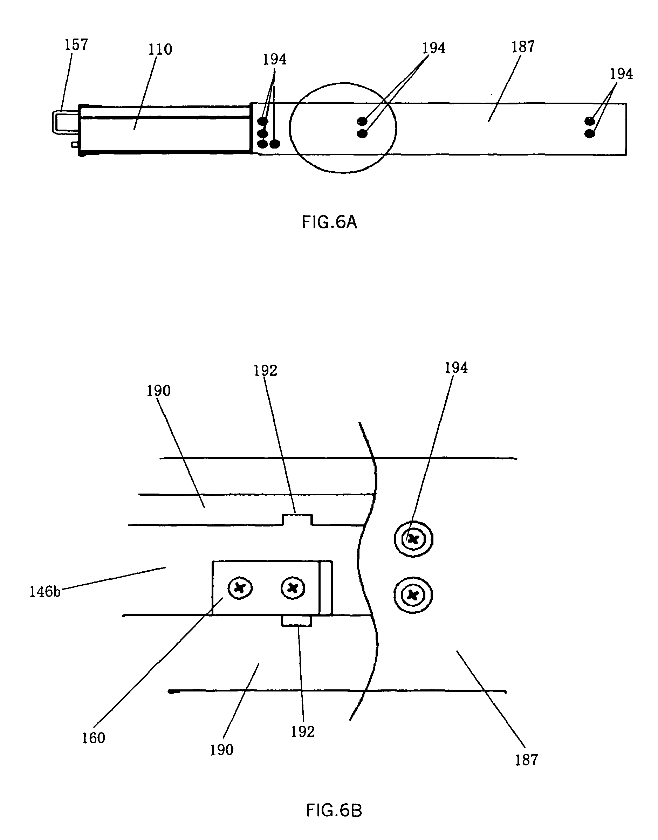

Each side plate 187 stands approximately perpendicular to the bottom plate 181, and has the fixing part 188 with two screw holes 189 at its front surface, a rail 190, and a projection 196. The fixing part 188 is fixed, as shown in FIG. 1, onto the frame 12 through the screw holes 12a, 189 and the screws 14. In addition, as shown in FIGs. 6A and 6B, the U-shaped rail 190 and projection 196 are provided at the side facing the tray part 110 of the side plate 187.

The rail 190 has two notches 192. A connection of the stopper 160 of the tray part 110 to the rail 190 makes the tray part 110 movable relative to the bracket part 180. The moving tray part 110 stops, when the stopper 160 is engaged with the notches 192. Thus, the stopper 160 and the notches 192 prevent the optical fiber cable 400 and the power cable 354 from being severed as well as the tray part 110 from coming off from the bracket part 180 due to the excessive pulling of the tray part 110.

The media converter 200 converts a signal for one medium to a signal for a different medium, such as the UTP cable to the optical fiber cable 400. Such a media converter 200 may use, for example, MMC100 Series (including MMC101, MMC102, MMC103, and MMC103LH) produced by Allied Telesis Kabusiki Kaisha. The media converter 200 includes, as shown in FIG. 7A, the front, top, rear, and bottom surfaces 210, 220, 230 and 240.

The front surface 210 includes, as shown in FIG. 7A, a 100BASE-TX port 212, a link test switch 214, and three setup-confirming LED lamps 216.

The 100BASE-TX port 212 is a connector to be connected to a UTP cable (not shown) that is connected to an external device, such as a hub in the Ethernet. The 100BASE-TX port 212 has an automatic recognition function of Full Duplex / Half Duplex, and operates in a mode in accordance with an external device to be connected.

The link test switch 214 is a switch to select a normal mode that indicates connection statuses of two communication devices to be connected to the 100BASE-TX port 212 and the 100BASE-FX port 214, which will be described below, and a test mode that indicates whether a link is established between this port and a connected device.

The LED lamps 216 are used to confirm a configuration for communications, and include an LED lamp 216a for identifying a link test, an LED lamp 216b for identifying a connection of the 100BASE-FX port 232, and an LED lamp 216c for identifying the 100BASE-TX port 212.

The top surface 220 includes a communication mode switch 222, and an MDI/MDI-X switch 224. The communication mode switch 222 is a switch to set up the communication mode (Full Duplex / Half Duplex), and selects the same communication mode as that of the device connected to the 100BASE-FX port 232. The MDI/MDI-X switch 224 is a switch to determine whether the 100BASE-TX port 212 is used as a cascade connection port or as a normal MDI-X port.

The rear surface 230 includes 100BASE-FX port 232, and a DC jack 234. The 100BASE-FX port 232 is a connector to which an optical fiber cable 400 is connected. The DC jack 234 is a connector to which a DC cable 340 is connected. The optical fiber cable 400 is connected, for example, to an optical network.

The power unit 300 is screwed onto the upper plate part 120. The power unit 300 supplies power to the media converter 200, and includes twelve DC cable inlets 302 and one power cable 354. The DC cable 340 is inserted into the DC cable inlet 302, and each media converter 200 is supplied power through the DC cable 340.

A plug 352 is connected at the top of the power cable 354. The power unit 300 is electrified by inserting the plug 352 into an external, electric outlet (not shown). The power unit 300 includes radiation holes at its top, rear, and side surfaces, protecting internal circuits from thermal damages.

The optical fiber cable 400 is a cable for optical communications, and made of thin fiber of dielectric, such as transparent glass and plastic. Structurally, it includes a core of a large refractive index at its center, and a clad of a small refractive index around the core. An electric signal converted into a light signal propagates through the core while totally reflected due to the difference of refractive indexes between the core/clad boundaries. The optical fiber cable 400 has a multimode that allows multiple modes to be transmitted due to the difference of refractive indexes between the core/clad boundaries and core's diameter, and a single mode that allows only one mode to be transmitted. Advantageously, the optical fiber cable 400 has such small attenuation that it may achieve a long-distance transmission without any interconnecting device. In addition, because of its thin cable diameter and large transmission amount of 100Mbps to several Gbps, the optical fiber cable 400 has a larger transmission amount per cable's sectional area than that of the metal cable. On the other hand, the optical fiber cable 400 is disadvantageously vulnerable to bending, and damaged by excessive bending.

A description will now be given of an attachment, exchange, and wire configuration of the media converter 200. In attaching the media converter 200, the sub-rack 100 is drawn from the bracket 180 by a predetermined distance and the media converter 200 is then mounted onto the bridge part 132 at a desired position on the tray part 110 so that the front surface 210 of the media converter 200 faces the window 153 and the top surface 220 faces up. Next, the media converter 200 is screwed from the backside through the opening 144 and hole 133. The screwing step is omitted for the bridge parts shown in FIGs. 4A and 4B.

Following the screwing step, the UTP cable is connected to the 100BASE-TX port 212, the DC cable 2340 is connected to the DC cable inlet 302 in the power unit 300, and the optical fiber cable 400 is connected to the 100BASE-FX port 234. The optical fiber cable 400 may be pulled out from the notch 154 at the front surface or from the rear surface.

The reverse procedure is repeated in exchanging the media converter 200.

Thus, only when the sub-rack 100 is drawn off from the bracket part 180 by a predetermined distance, the media converter 200 is conveniently attached and exchanged without removing the upper sub-rack 100. The notches 192 provided at the rail 190 and the stopper 160 provided at the tray part 110 prevent the tray part 110 from coming off from the bracket part 180.

Since the optical fiber cable 400 may be pulled out from both the front and rear surfaces, the optical fiber cable 400 may be connected to the network device whether the network device connected to the optical fiber cable 400 is located at the front side or at the rear side of the accommodation apparatus 10. In addition, the bottom plate 141 accommodates the surplus portion of the optical fiber cable 400, preventing the optical fiber cable 400 from being sharply bent and broken.

The optical fiber cable 400 may be pulled out without being bent at a corner of the media converter 200 or the power unit 300. For example, in an attempt to pull out the optical fiber cable 400 from the backside of the sub-rack 100, the optical fiber cable 400 does not pass the area 127 next to the power unit 300 as in the prior art, and thus the optical fiber cable 400 does not get damaged.

A description will now be given of an attachment, exchange, and wire configuration of the power unit 300. First, the power unit 300 is screwed onto the upper plate part 120 of the tray part 110. In general, the power unit 300 is attached to the upper plate part 120 before any one of the media converters 200 is attached, and before the upper plate part 120 is attached to the lower plate part 140. Of course, after the tray part 110 has been already assembled, the power unit 300 may be attached using the cutout portion 145 in the bottom plate 141 of the lower plate part 140. After the sub-rack 100 is attached to the accommodation apparatus 10, the tray part 110 is drawn off from the bracket part 180 by a predetermined distance.

Next, the power cable 354 of the power unit is pulled out through any one of the slits 186. Which slit 186 is selected depends upon the positional relationship between the plug 352 and the external, electric outlet. The tie 360 is connected to the slit 186 in the bracket 180 to bunch the surplus portion of the power cable 354.

The reverse procedure is repeated in exchanging the power unit 300. Since each media converter 200 is independently supplied power from the power unit 300, an exchange of one media converter 200 does not affect another media converter 200.

Thus, only when the sub-rack 100 is drawn off from the bracket part 180 by a predetermined distance, the media converter 200 is conveniently attached and exchanged without removing the upper sub-rack 100. In addition, the tie 360 bunches and fixes the power cable 354. The slits 186 facilitate the electric connection between the plug 352 and the external, electric outlet. Since the slit 186 extends in the moving direction (*i*.*e*., the direction M) of the tray 110, the power cable 354 moves along the slit as the tray part 110 moves, without damages and disconnection.

Next, a description will be given of the operation and change of the operation of the media converter 200. After the media converter 200 is attached to the tray part 110, the communication mode switch 222 and the MDI/MDI-X switch 224 are operated. The communication mode switch 222 selects the Full Duplex (bi-directional simultaneous communication) or the Half Duplex (one-way directional communications). After the UTP cable is connected, the MDI/MDI-X switch 224 provided at the top surface 210 of the media converter 200 selects and sets up the a HUB (for use as a cascade connection port with a repeater or switch) or an XPC (for use as a normal 100BASE-TX port). The similar procedure applies to the setup change.

The configuration of the media converter 200 may be confirmed using the link test switch 214 and the LED lamps 216 provided at the front surface 210.

Thus, only when the sub-rack 100 is drawn from the bracket part 180 by a predetermined distance, the media converter 200 is conveniently operated without removing the upper sub-rack 100.

Thus, there is provided an accommodation apparatus that facilitates attachments, exchanges, operations, and wire configurations of a communication device, such as a media converter, a power unit, and the like.

## Claims

1. An accommodation apparatus (10) for accommodating a power unit (300) and a plurality of communication devices to be connected to a transmission medium (400), said accommodation apparatus comprising:
a plurality of sub-racks (100), the sub-racks being piled in a height direction (H) in the apparatus, each sub-rack including:
a support part (180) fixed onto a frame external to the sub-rack (12); and
a loading part(110), which is configured to detachably accommodate a plurality of communication devices arranged in a width direction (N); the loading part being configured to accommodate the power unit and move relative to said support part in a length direction (M) so that the plurality of communication devices and the power unit can be loaded onto and unloaded from the loading part;
**characterized in that**
the loading part includes a first loading member (120) and a second loading member (140) that are disposed at different heights from each other in the loading part, the first loading member being configured to accommodate the power unit and the second loading member being configured to accommodate the transmission medium at a height different from that of the power unit, and the first and second loading members being configured to move as one member when the loading part moves relative to the support part.

2. An accommodation apparatus according to claim 1, wherein the loading part further includes a front plate part (150) that is arranged perpendicular to the bottom surfaces of the first and second loading members and has a notch (154) extending in the width direction, the second loading member being configured to accommodate the transmission medium at a height different to that of the communication device whereby the transmission medium can be drawn out of the loading part in two directions along the length direction.

## Patentansprüche

1. Eine Aufnahmevorrichtung (10) zum Aufnehmen eines Netzteils (300) und einer Mehrzahl von Kommunikationsvorrichtungen, die mit einem Übertragungsmedium (400) verbunden werden sollen, während die Aufnahmevorrichtung umfasst:
eine Mehrzahl von Untergestellen (100), während die Untergestelle in einer Höhenrichtung (H) in der Vorrichtung gestapelt sind, wobei jedes Untergestell aufweist:
ein Unterstützungsteil (180), das auf einem von dem Untergestell externen Rahmen (12) befestigt ist, und
ein Ladeteil (110), das konfiguriert ist, um abnehmbar eine Mehrzahl von Kommunikationsvorrichtungen aufzunehmen, die in einer Breitenrichtung (N) angeordnet sind, während das Ladeteil konfiguriert ist, um das Netzteil aufzunehmen und sich in Bezug auf das Unterstützungsteil in einer Längsrichtung (M) zu bewegen, so dass die Mehrzahl von Kommunikationsvorrichtungen und das Netzteil geladen werden können auf und entladen werden können von dem Ladeteil,
**dadurch gekennzeichnet, dass**
das Ladeteil ein erstes Ladeelement (120) und ein zweites Ladeelement (140) umfasst, die in unterschiedlichen Höhen voneinander in dem Ladeteil angeordnet sind, während das erste Ladeelement konfiguriert ist, um das Netzteil aufzunehmen, und das zweite Ladeelement ist konfiguriert, um das Übertragungsmedium in einer Höhe aufzunehmen, die verschieden ist von der das Netzteils, und die ersten und zweiten Ladeelemente sind konfiguriert, um sich als ein Element zu bewegen, wenn das Ladeteil sich in Bezug auf das Unterstützungsteil bewegt.

2. Eine Aufnahmevorrichtung gemäß Anspruch 1, in der das Ladeteil weiterhin einen Frontplattenteil (150) umfasst, der rechtwinklig zu den Bodenoberflächen der ersten und zweiten Ladeelemente angeordnet ist und eine Kerbe (154) aufweist, die sich in der Breitenrichtung erstreckt, während das zweite Ladeelement konfiguriert ist, um das Übertragungsmedium in einer Höhe aufzunehmen, die verschieden ist von der der Kommunikationsvorrichtung, wodurch das Übertragungsmedium aus dem Ladeteil in zwei Richtungen entlang der Längsrichtung herausgezogen werden kann.

## Revendications

1. Appareil de logement (10) pour loger une unité de puissance (300) et une pluralité de dispositifs de communication à connecter à un support de transmission (400), ledit appareil de logement comprenant:
une pluralité de sous-paniers (100), les sous-paniers étant empilés dans le sens de la hauteur (H) dans l'appareil, chaque sous-panier comportant:
une partie de support (180) fixée sur un châssis externe au sous-panier (12); et
une partie de chargement (110) qui est configurée pour loger amoviblement une pluralité de dispositifs de communication agencés dans le sens de la largeur (N); la partie de chargement étant configurée pour loger l'unité de puissance et pour se déplacer relativement à ladite partie de support dans le sens de la longueur (M) de sorte que la pluralité de dispositifs de communication et l'unité de puissance peuvent être chargés sur et déchargés de la partie de chargement;
**caractérisé en ce que**
la partie de chargement comporte un premier élément de chargement (120) et un deuxième élément de chargement (140) qui sont disposés à des hauteurs différentes l'un de l'autre dans la partie de chargement, le premier élément de chargement étant configuré pour recevoir l'unité de puissance et le deuxième élément de chargement étant configuré pour recevoir le support de transmission à une hauteur différente de celle de l'unité de puissance, et les premier et deuxième éléments de chargement étant configurés pour se déplacer comme un élément lorsque la partie de chargement se déplace relativement à la partie de support.

2. Appareil de logement selon la revendication 1, dans lequel à partie de chargement comporte en outre une partie de plaque avant (150) qui est agencée perpendiculairement aux surfaces inférieures des premier et deuxième éléments de chargement et présente une encoche (154) s'étendant dans le sens de la largeur, le deuxième élément de chargement étant configuré pour recevoir le support de transmission à une hauteur différente de celle du dispositif de communication par quoi le support de transmission peut être extrait de la partie de chargement dans deux directions le long de la direction en longueur.
